# EUROPEAN PATENT APPLICATION

(11) **EP 1 202 353 A1**
(43) Date of publication of application: **02.05.2002**
(21) Application number: 00830712.6
(22) Date of filing: 27.10.2000
(51) Int. Cl.: H01L 27/112, H01L 21/8246, H01L 27/02

(54) **Mask programmed ROM and method of fabrication**

(71) Applicant: STMicroelectronics S.r.l., 20041 Agrate Brianza (Milano) (IT)
(72) Inventor: Vajana, Bruno, 24100 Bergamo (IT); Patelmo, Matteo, 20056 Trezzo Sull'Adda (IT)
(74) Representative: Pellegri, Alberto

(57) **Abstract**

A read only memory device, mask programmable during the fabrication of the device, comprises a plurality of memory cells formed onto a semiconductor substrate and organized in rows and columns to form an array of memory cells, the memory cells belonging to a same row sharing a common gate functioning as address wordline, each cell comprising a first region and a second region of type of conductivity opposite to that of the semiconductor substrate, a first dielectric layer formed on the plurality of memory cells, first contacts with the first regions of the cells through the first dielectric layer, connecting in common the first regions to a node of the device at a reference voltage, second contacts, each one established with a respective second region through the first dielectric layer and through a second dielectric layer formed on the first dielectric layer, and intercepted by a respective bitline.

Data stored in such a memory are made undecipherable by optical inspection if the second contacts are established with the second regions of only the memory cells programmed in a conductive state; interconnection contacts and false interconnection contacts are formed through the second dielectric layer, each geometrically above and in electrical continuity with one of the second contacts or geometrically above and in electrical discontinuity with one of the non contacted second regions of memory cells programmed in non conductive state; each bitline defined over the second dielectric layer, intercepting interconnection contacts and false interconnection contacts with the second regions of the cells belonging to a same column of the array.

## Description

### FIELD OF THE INVENTION

The invention relates in general to read only memory devices (ROM) and in particular to ROM devices that may be programmed by using appropriate masks during the fabrication process.

### TECHNOLOGICAL BACKGROUND

Configurations of functional integrated circuits, standing programs in digital devices such as microcomputer and/or microprocessor systems, non modifiable codes and other data permanently stored onto "smart cards" and similar integrated devices are commonly stored in read only memory devices, commonly known as ROM (acronym of Read-Only-Memory), realized by the manufacturer of semiconductor devices according to specification and coding of the customer.

In practice data are permanently stored in ROM devices at a certain step of their fabrication process.

As in any other static memory device composed by a matrix of cells ordered in rows and columns and individually addressable through mutually orthogonal lines, called wordline and bitline, the logic value of each single bit is set by making conductive or non conductive the corresponding cell.

According to a common convention, a conductive cell corresponds to the logic value "0" while a non conductive cell corresponds to the logic value "1".

Such ROM devices need a customization at a certain point of the fabrication process. For economic reasons it would be preferable to carry out the permanent storage of data in the cells of the memory matrix as late as possible in the fabrication process, in order to follow the steps of a standard process as far as possible before such a necessarily customizing step thus allowing important scale production savings.

Generally each single cell is constituted by a field effect transistor (typically a MOS transistor), whose source is commonly connected to a common node at a reference voltage, typically a ground voltage.

Transistors (cells) disposed along a same row of the matrix or of a block or sector in which the whole matrix may be subdivided, share a control electrode or gate that functions also as address wordline.

Traditionally the programming of the ROM matrix is carried out by using a dedicated mask to establish or not a connection of the drain of each single cell to the respective address bitline.

The unconnected cells will provide the logic datum "1" while the connected cells will provide the logic datum "0", according to the commonly adopted convention.

For the above mentioned economic reasons of mass production, alternative programming systems have been developed that are no longer based on the realization or not of a physical electrical connection of the drain region of the single cell. Alternative programming techniques are based on carrying out dopant counterimplants onto areas corresponding to the drain region of selected cells through dedicated masks, in order to raise the turn-on threshold of the MOS transistor to a sufficiently high level for all the cells to be programmed in a non conducting state (logic "1"). Typically, these counterimplants are carried out at relatively high energies, through pre-formed insulating and interconnecting layers.

Though these alternative techniques satisfy the need of carrying out the customization as late as possible in the fabrication process of the device, they tend to become unsuitable with the scaling down of integrated circuits.

In ULSI devices of new and future generation, wherein minimum dimensions (linewidth) may be of the order of decimal fractions of µm, these programming techniques by masked high energy counterimplants loose reliability and in such demanding conditions it has been found necessary to use a classic programming technique by establishing or not an electrical connection of the drain of the cells to be programmed in conduction, using modern techniques to form contacts based on the filling of contact holes of extremely small dimensions with a refractory metal (W) that can be deposited from a vapor phase (CVD).

The plugs of tungsten or of any other equivalent metal are then connected by way of intercepting conductive lines defined in a first level metallization layer (metal 1), for example of aluminium.

US-A-5,925,917 discloses a ROM device and the relative fabrication method, according to which, after having formed source and drain contacts on all the cells of the memory array, according to normal techniques used for defining and opening contact holes through an insulating dielectric layer and for successively filling them by depositing and attacking a filler metal of contacts, a second dielectric layer is deposited through which, using a dedicated programming mask holes for "interconnection contacts" are opened to establish an electrical continuity with the performed underlying filler metal plugs of the contacts relative to the cells to be programmed in conduction state.

Special circuit configurations, programs and codes, personal codes and alike data commonly destined to be stored in such ROM devices are proprietary information of the customer and/or of the person to whom data and codes permanently stored in the ROM memory device pertain. It is evident that such information is confidential and must be made undecipherable as much as possible.

Modern optical inspection techniques (with a microscope) commonly used in reverse engineering operations are able to detect the programming features of a ROM array and thus to access codes and data that are permanently stored in it.

Indeed, the interconnection contacts realized through the second dielectric layer according to the method described in the above mentioned document, can be easily recognized even if intercepted (partly covered) by first level metal line (metal 1), patterned onto the surface of the second dielectric layer. In practice, the point along the metal line at which there is a interconnection contact underneath can be easily discriminated from a point at which the expected interconnection contact is in fact absent. In this way the cells programmed as "0" can be easily discriminated from cells programmed as "1" thus allowing the deciphering of data stored in the ROM memory.

### OBJECT AND SUMMARY OF THE INVENTION

It has been found and is the object of the present invention a read only memory structure realizable according the most advanced fabrication techniques and programmable by employing a dedicated mask, the stored data of which are substantially undecipherable by a reverse engineering technique including optical inspection with a microscope.

According to the method for realizing a read only memory device of the invention, interconnection contacts and false interconnection contacts are formed through a second insulating dielectric layer formed onto a first insulating dielectric layer through which source contacts and drain contacts only of the memory cells to be programmed in conductive state have been previously realized, thus completing the electric connection of the drain contacts of the cells programmed in conduction state to the respective bitline defined in metal 1, while producing at the same time false interconnection contacts to the respective bitlines of memory cells programmed in non conduction state and thus not having an underlying drain contact.

In this way even carrying out reverse engineering operations onto the device, the optical inspection will indistinctly detect the presence of true interconnection contacts and of false interconnection contacts that will be practically indistinguishable from one another.

The deciphering of data permanently stored in the read only memory array could take place only by carrying out and analyzing microsections of such a huge number of devices, to be economically prohibitive.

The invention is more precisely defined in claims 1 and 7.

### BRIEF DESCRIPTION OF THE DRAWINGS

**Figure 1** is an electric diagram of a memory array fragment constituted by four memory cells.

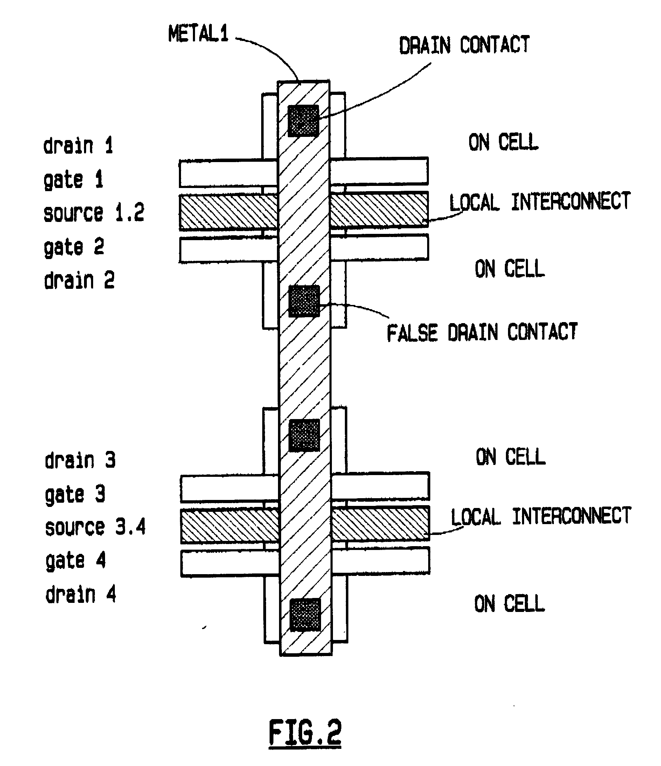

**Figure 2** is the layout of a two-cell portion of the fragment of Fig. 1.
**Figures 3** and **4** show microsections of a cell programmed in a conductive state and of a cell programmed in a non conductive state.
**Figure 5** shows the layout that would be observed in a reverse engineering operation.

### DESCRIPTION OF AN EMBODIMENT OF THE INVENTION

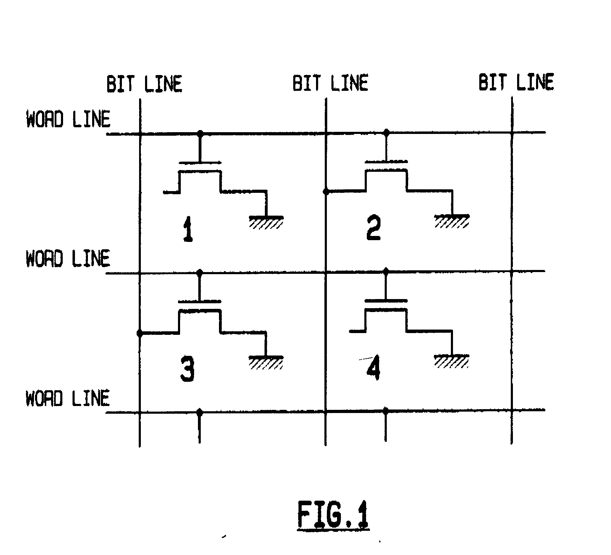

A representative portion of the electric diagram of the cell array of a read only memory is depicted in Fig. 1.

The single memory cells are MOS transistors, whose source is typically connected in common to the node at the reference voltage of the memory circuit, typically at ground potential.

The gate of cells belonging to the same row of the array is connected to a common wordline.

According to the architecture of a read only memory of the invention, the cells programmed in a conductive state of a same column of the array have their drains connected to a respective common bitline, while the drains of the cells permanently programmed in non conduction state is not connected.

Access to selected cells takes place through normal row and column decoding circuits by stimulating the wordline relative to the row containing the cells constituting the addressed unit of information (for example the byte or word), while the single cells (bit) are individually selected to read the stored information by stimulating in succession the selected bitlines.

In the portion depicted in Fig. 1, the cell 1 and the cell 4 are permanently programmed in non conductive state by not realizing the respective drain connections, while cells 2 and 3 are permanently programmed in a conductive state by connecting the drain to the respective bitline.

The method of fabrication of a read only memory device, mask programmable during the fabrication process of the device of the present invention, is based on techniques employed in advanced CMOS processes in which local interconnections LIL (Local Interconnect Layer) are used to realize connections, often referred to as interconnections or vias, among conductive elements defined on different levels as well as contacts with active areas of the semiconductor.

In these processes, the contacts on active areas (and eventually the true interconnection contact or vias) are realized in two steps: with a first masking and etching step that defines the contacts through a first dielectric layer, the "lower part" of contacts on the active areas (and eventually also on polysilicon) is realized, while with a second masking and etching step the interconnection vias and, at the same time, also the "upper part" of contacts on the active areas (and eventually also on polysilicon) is realized through a second dielectric layer previously formed onto the first dielectric layer and onto the top faces of the "lower parts" of the contacts.

According to an essential feature of the present invention, by means of this second mask, already contemplated in a LIL process, besides completing the formation of metal plugs of real contacts on active areas and more precisely the drain contacts of the cells to be programmed in conductive state (by contacting the tops of the lower parts of the contacts realized with the first masking step through interconnection contacts) as well as eventual real contacts on polysilicon, false interconnection contacts are also purposely formed geometrically above the underlying drain areas of cells programmed in a non conductive state.

The illustrated fabrication process is a typical CMOS process for realizing devices including logic circuits and/or read only memory devices, however the LIL technique and the invention may be implemented in the sequence of manufacturing steps of any other manufacturing process of integrated devices.

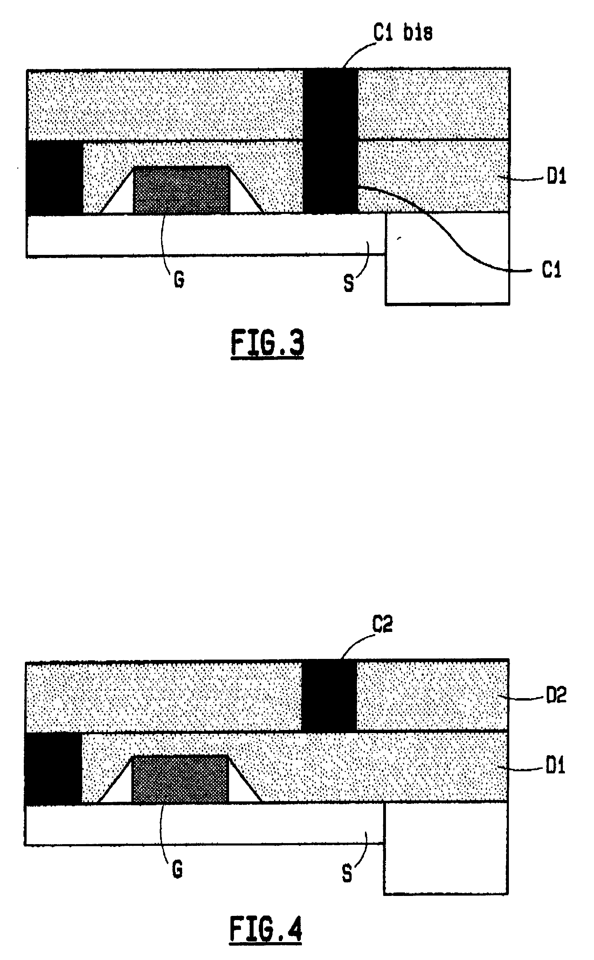

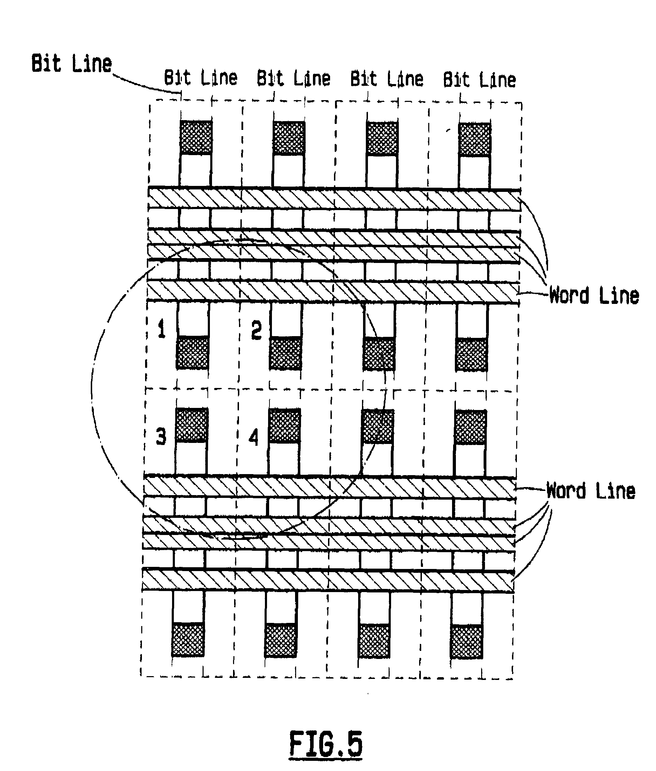

The resulting structure is depicted in Figs. 3 and 4, the first one depicts a memory cell (transistor) programmed in a conductive state and the second one depicts a cell (transistor) programmed in non conductive state.

Referring to the sections depicted in Figs 3 and 4, according to a conventional process, the memory cells (transistors) are formed onto a semiconductor substrate S.

After having defined the active areas, gate oxide layers on the active areas of transistors are formed onto the substrate.

In a common manner, a first polysilicon layer is deposited, doped and patterned to form the gates G of transistors.

After having so formed the active elements (transistors), a first of a dielectric material is deposited. Typically this layer is formed by chemical vapor deposition technique or CVD. This first dielectric layer D1 may be preferably composed of BPSG, that is of a silicon oxide doped with phosphorous and boron. Depending on the specific application of the device, other dielectrics may be used, such as undoped oxides or PSG or oxy-nitrides. In any case, the layer D1 must have good conformability and dielectric properties, typical of a pre-metallization layer.

Preferably the first dielectric layer D1 is planarized. The aim of this operation is to reduce as much as possible stresses in the layers that will be formed successively onto the first layer D1.

Planarization may be customarily realized by a CMP technique, i.e. Chemical Mechanical Polishing that is by a chemical-mechanical surface treatment. Planarization may be carried out even with different known techniques, for example by thermal reflowing the dielectric material.

Of course, this process step is optional. In fact, should the first dielectric layer D1 as deposited be sufficiently planar, a specific planarization step may be unnecessary.

Whether planarization is carried out or not, the final thickness of the first dielectric layer D1, is generally comprised between 200 and 1000nm.

Thereafter, apertures through the first dielectric layer D1 are formed by masking and successive etching. These holes are created only in correspondence of the active areas that must be electrically connected through contacts.

The holes so produced through the thickness of the first dielectric layer D1 expose active areas on the silicon (and eventually areas on the polysilicon).

According to the method of mask programming of the invention, the active drain areas not to be connected of cells to be programmed in non conductive state, and in correspondence of which false interconnection contacts will be successively formed, are not exposed.

Successively and in a conventional manner, the holes so formed through the first dielectric layer D1 are filled with a conductive material, preferably according to well known technique for realizing so-called tungsten plugs C1.

According to the local interconnection layer (LIL) technique, many of the holes being filled in this phase of the process in other parts of the integrated circuit may constitute so-called local interconnection vias.

According to a preferred technique, for realizing tungsten plugs C1, a so-called barrier layer comprising a double layer of titanium and titanium nitride (Ti/TiN) is deposited first, followed by the deposition of a filling tungsten layer that is eventually etched back by a CMP technique in order to leave tungsten only inside the contact (and vias) holes, so realizing the plugs C1.

A second dielectric layer D2 is then deposited.

This second dielectric layer D2 is preferably formed by a CVD technique. Preferably it is constituted by a TEOS (tetraethylorthosilicate) layer. Of course, this second layer D2 may be constituted by a different dielectric material, for example by a different oxide, doped or not, or even by an oxy-nitride, as long as it has satisfactory chemical-physical and morphological characteristics to ensure a good electric insulation of the underlying active structures. If necessary, even this second dielectric layer D2 may be planarized by any suitable technique. The final thickness of the second dielectric layer D2 can be generally comprised between 200 and 1500nm.

Successively a second masking and etching step is carried out for forming interconnection contacts C2, according to the local interconnect layer (LIL) technique.

According to the fundamental aspect of the present invention, the mask is defined with apertures coincident with true drain contacts (C1, C1bis) as well as with false drain contacts (C2).

The second dielectric layer D2 is etched to form a first plurality of holes C1 bis in correspondence of the underlying already formed tungsten plugs C1 and a second plurality of holes C2 that end at their bottom substantially on the first dielectric layer D1.

Successively, all the holes C1bis and C are filled, typically with tungsten with the same technique already used, form the bottom portions of the tungsten plugs.

The opening of the false contacts C2 is easy and does not introduce any critical aspect because the etching can be stopped automatically onto the first dielectric layer D1.

According to the normal fabrication process, a first metallization layer (commonly of aluminium or of an alloy thereof) will be deposited from which, by a conventional masking and etching step, interconnecting conductive lines will be defined, among which also the address bitlines of the array of read only memory cells.

In practice, the read only memory array of the invention, realized according to the method above described in its essential steps, will appear as schematically depicted in Fig. 5 during an eventual inspection using reverse engineering techniques.

In practice, the investigation will detect the presence of drain contacts (true or false) for all memory cells, thus making practically undecipherable the true programming state of the cells.

The interconnection contacts present at locations coincident with the drain areas of the four cells of the diagram of Fig. 1 are highlighted in the partial view of Fig. 5.

As a matter of fact, only the interconnection contacts 2 and 3 establish an electrical continuity with the underlying drain area of a respective transistor, while the false interconnection contacts 1 and 4, even if they look like true contacts, in reality are metal plugs that penetrate only as far as the upper face of the underlying first dielectric layer D1 and even if they are eventually intercepted alike the real drain contacts by the respective bitline, they do not produce any electrical effect.

## Claims

1. A read only memory device, mask programmable during the fabrication of the device, comprising a plurality of memory cells formed onto a semiconductor substrate and organized in rows and columns to form an array of memory cells, the memory cells belonging to a same row sharing a common gate functioning as address wordline, each cell comprising a first region and a second region of type of conductivity opposite to that of the semiconductor substrate, a first dielectric layer formed on said plurality of memory cells, first contacts with said first regions of the cells through said first dielectric layer, connecting in common said first regions to a node of the device at a reference voltage, second contacts, each one established with a respective second region through said first dielectric layer and through a second dielectric layer formed on said first dielectric layer, and intercepted by a respective bitline, **characterized in that**
said second contacts are established with the second regions of only the memory cells programmed in a conductive state;
interconnection contacts and false interconnection contacts are formed through said second dielectric layer, each geometrically above and in electrical continuity with one of said second contacts or geometrically above and in electrical discontinuity with one of said non contacted second regions of memory cells programmed in non conductive state;
each bitline defined over said second dielectric layer, intercepting interconnection contacts and false interconnection contacts with the second regions of the cells belonging to a same column of said array.

2. The memory device according to claim 1, wherein said first and second contacts, said interconnection contacts and said false interconnection contacts are made primarily of tungsten.

3. The memory device according to claim 2, wherein said first and seconds contacts comprises a barrier layer in contact with the semiconductor substrate.

4. The memory device according to claim 3, wherein said barrier layer is made of a material belonging to the group composed of titanium, titanium nitride and stacked layers thereof.

5. The memory device according to any of the preceding claims, wherein said bitlines are of aluminium or alloys thereof.

6. The memory device according to anyone of the preceding claims, wherein said gates functioning as wordlines are of polysilicon or of doped polysilicon.

7. A method of fabricating a mask programmed read only memory device comprising forming a plurality of memory cells onto a semiconductor substrate geometrically arranged in rows and columns to constitute an array of cells, the memory cells belonging to a same row sharing a common control gate functioning as address wordline, each cell comprising a first region and a second region of a type of conductivity opposite to that of the semiconductor substrate, depositing a first dielectric layer on said plurality of memory cells, realizing first contacts with said first regions of the cells through said first dielectric layer connecting in common said first regions to a node of the device at a reference voltage and second contacts, each one established with a respective second region, depositing a second dielectric layer on said first dielectric layer being intercepted by a respective bitline, **characterized in that** it comprises the following steps
forming interconnection contacts and false interconnection contacts through said second dielectric layer, respectively above and in electrical continuity with said second contacts and geometrically above and in electrical discontinuity with said second non contacted regions of memory cells to be programmed in non conductive state;
defining bitlines over said second dielectric layer, each intercepting the interconnection contacts and false interconnection contacts with the second regions of the cells belonging to a same column of said array.
